**Europäisches Patentamt**

**European Patent Office**

**Office européen des brevets**

(19)

(11) **EP 0 853 280 A2**

(12) **EUROPEAN PATENT APPLICATION**

(43) Date of publication:
15.07.1998 Bulletin 1998/29

(51) Int Cl.⁶: **G06F 11/263**

(21) Application number: **98100318.9**

(22) Date of filing: **09.01.1998**

(84) Designated Contracting States:
**AT BE CH DE DK ES FI FR GB GR IE IT LI LU MC NL PT SE**
Designated Extension States:
**AL LT LV MK RO SI**

(30) Priority: **10.01.1997 JP 14554/97**

(71) Applicant: **NEC CORPORATION**
**Tokyo (JP)**

(72) Inventor: **Otsuka, Shigekazu**
**Minato-ku, Tokyo (JP)**

(74) Representative:
**von Samson-Himmelstjerna, Friedrich R.,**
**Dipl.-Phys.**
**SAMSON & PARTNER**
**Widenmayerstrasse 5**
**80538 München (DE)**

(54) **Timing verification method and device**

(57)     There is disclosed a timing verification device for a synchronous circuit/asynchronous circuit mixed circuit which can verify timings of a synchronous circuit portion and an asynchronous circuit portion by means of a static timing verification. In an electric or electronic circuit, for a circuit mixed with a synchronous circuit which is synchronous with a specified clock signal and an asynchronous circuit which has no specified clock or is not synchronous with the specified clock signal, a verifying means is provided for assuring a timing only in a static timing verification method.

FIG. 2

## EP 0 853 280 A2

**Description**

BACKGROUND OF THE INVENTION

1. Field of the Invention

The present invention relates to a timing verification method and device which verify a design of an electric or electronic circuit.

2. Description of the Prior Arts

It needs to verify whether or not an electric circuit or an electronic circuit constituted of IC and LSI operates at a timing as designed. As the circuit available are a synchronous circuit in which a flip-flop, a latch circuit or another circuit element operates with one clock and an asynchronous circuit in which the circuit element operates with plural clocks. To verify the timing of the conventional synchronous circuit a static verification device is used for verifying a setup time or a hold time from one latch circuit to another latch circuit, while to verify timings of synchronous and asynchronous circuits a dynamic verification device is used for preparing a test pattern to perform a simulation.

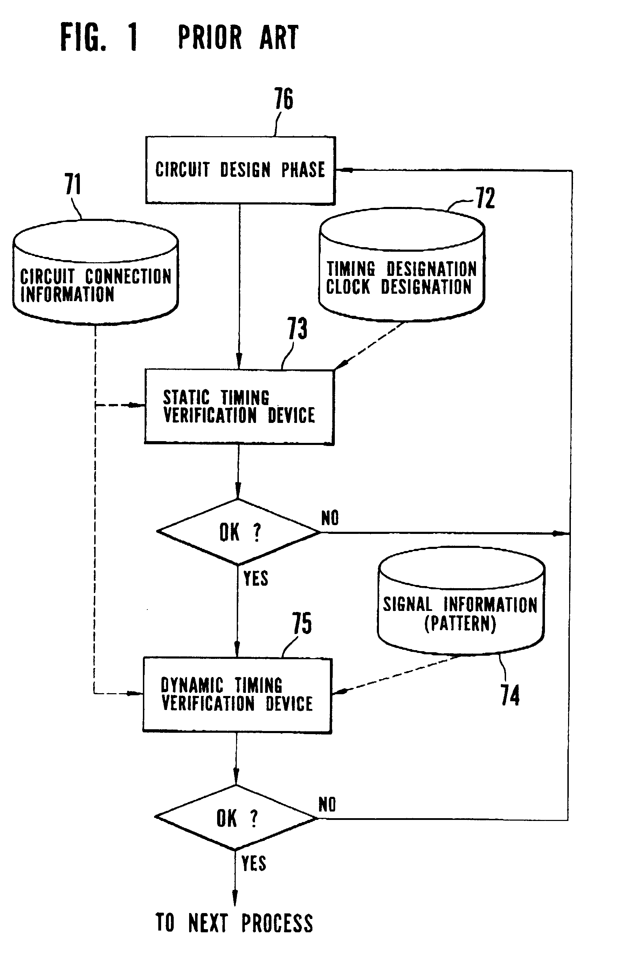

Fig. 1 is an explanatory view of a process flow in a conventional timing verification method for an electric or electronic circuit. In Fig. 1, reference numeral 71 denotes a circuit connection information to be verified, 72 a timing designation and clock designation information of an input/output signal, 73 a conventional static timing verification device, 74 a signal information (pattern), 75 a dynamic timing verification device and 76 a circuit design phase.

Operation is now described. The conventional static timing verification device 73 basically requires no signal information of each circuit element by means of simulation. By designating timing and clock of the input/output signal (refer to 72 in Fig. 1), a latest path (critical path) between latches is found to verify the setup timing by determining whether or not the critical path is in time as compared with a clock cycle. Also, a fastest path between the latches is found to verify the hold timing by determining whether or not the next data is taken in at the timing of the same clock.

In the conventional static timing device 73, only the timing of the synchronous circuit is verified.

Subsequently, the dynamic timing verification device 75 shown in Fig. 1 requires the signal information (test pattern) 74 of each circuit element by means of simulation. By transmitting the signal information 74 into an input terminal of the circuit connection information 71, the circuit connection of the verified circuit is activated and simulation is performed.

In a predetermined clock cycle, it is determined by tracing a state of an output terminal of the circuit connection information 71 whether or not the circuit connection of the verified circuit is operated as expected. Thus, the setup timing, the hold timing, a spike timing or another timing is verified.

Further, a publication of patent application laid-open No. Hei 4-288677 proposes a constitution of a timing verification device for a synchronous/asynchronous mixed type of circuit to be verified in which synchronous/asynchronous circuit portions are automatically identified. By dividing the circuit to be verified into respective circuit portions, the timing of each circuit portion can be appropriately verified, so that all the timing problems can be found in a short time. In the device, first only the synchronous circuit portion which requires no test pattern is checked, and for the remaining circuit portion the timing verification for which the test pattern is necessary is performed.

A problem with the conventional timing verification operation lies in that the conventional static verification device only verifies the timing of the synchronous circuit with a designated clock. Therefore, the timing of the asynchronous circuit portion has to be verified by using a separate dynamic timing verification device.

However, when the asynchronous circuit is verified by using the dynamic timing verification device, the signal information with which a malfunction of the asynchronous portion can be detected is necessary. Disadvantages are that preparation of the information takes time and much simulation time is required. Further, only when tracing an output of the circuit connection information to determine whether or not the output data is a desired data, it is known whether or not the timing of an internal circuit is satisfactory. Therefore, if output information provides no expected value, it disadvantageously takes much time to analyze in which connection portion of the circuit connection information a timing violation occurs.

The reason for the above is that since the conventional static timing verification device can easily verify the timing of the synchronous circuit portion, but hardly verify the timing of the asynchronous circuit portion, the timing verification of the asynchronous circuit portion is performed only by the dynamic timing verification device.

SUMMARY OF THE INVENTION

For principle and operation of the invention, for static timing verification, paths of an asynchronous circuit portion for which timing must be assured and an information for designating a delay relationship among paths are transmitted. Thereby, a static timing verification device extracts the delay of the designated paths and verifies based on the delay data whether or not a designated delay relationship is established, to verify the timing of the circuit.

Wherefore, an object of the invention is to provide a timing verification device for a synchronous/asynchronous mixed circuit which can verify timings of a synchronous circuit portion and an asynchronous circuit portion by means of a static timing verification.

Another object of the invention is to provide a timing verification device which can largely reduce a time necessary for timing verification.

To attain this and other objects, the invention provides a timing verification method for a synchronous circuit/asynchronous circuit mixed circuit in which paths are designated in a circuit portion in which a delay becomes a problem associated with an asynchronous circuit portion, a delay information of the paths is obtained, and it is verified whether or not the delay information satisfies a designated delay relationship among the paths in the circuit portion. Thereby, the timing of the asynchronous circuit portion can be verified only by means of a static timing verification without using a test pattern.

Also, the present invention provides a timing verification device for verifying a timing of a synchronous circuit/ asynchronous circuit mixed circuit which is provided with a means for storing designated paths in a circuit portion having a problem of delay associated with an asynchronous circuit portion and a path relationship information and a means for verifying from obtained delay values of the designated paths whether or not the delay values of the paths satisfy a designated delay condition of the paths. Timings of not only the synchronous circuit but also the asynchronous circuit portion are verified only by means of a static timing verification without using a test pattern.

## BRIEF DESCRIPTION OF THE DRAWINGS

Fig. 1 is a flowchart showing a process in a prior-art timing verification system.
Fig. 2 is a flowchart of a timing verification process in an embodiment according to the invention.
Fig. 3 is a flowchart of a process in a static timing verification device according to an embodiment of the invention.
Fig. 4 is a circuit diagram showing a constitution of a sample circuit to depict a static timing verification method of an asynchronous circuit portion in an embodiment of the invention.
Fig. 5 is a timing chart of an operation in the sample circuit in Fig. 4.
Fig. 6 is circuit diagram showing a constitution of a sample circuit to depict a static timing verification method of an asynchronous circuit portion in another embodiment of the invention.
Fig. 7 is a timing chart of an operation in the sample circuit in Fig. 6.

## DETAILED DESCRIPTION OF THE PREFERRED EMBODIMENTS

The invention will now be described with reference to the accompanying drawings.

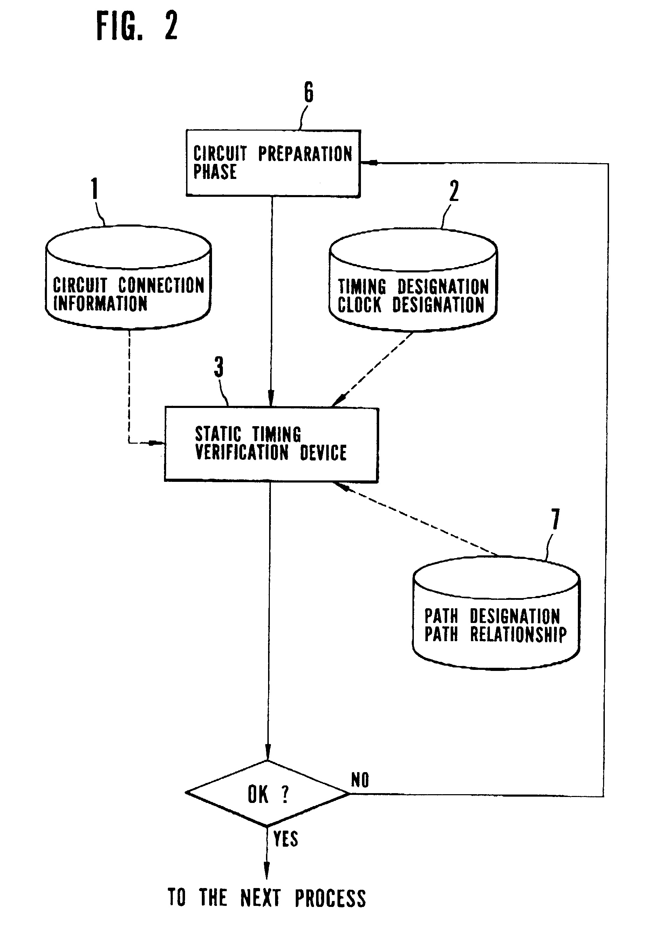

Fig. 2 is an explanatory view of a process flow in a timing verification method according to an embodiment of the invention. In Fig. 2, reference numeral 1 denotes a circuit connection information to be verified, 2 a timing designation and clock designation information of an input/output signal, 7 an information for designating paths to be measured in an asynchronous circuit portion and designating a relationship between the paths, 5 a static timing verification device and 6 a circuit preparation phase.

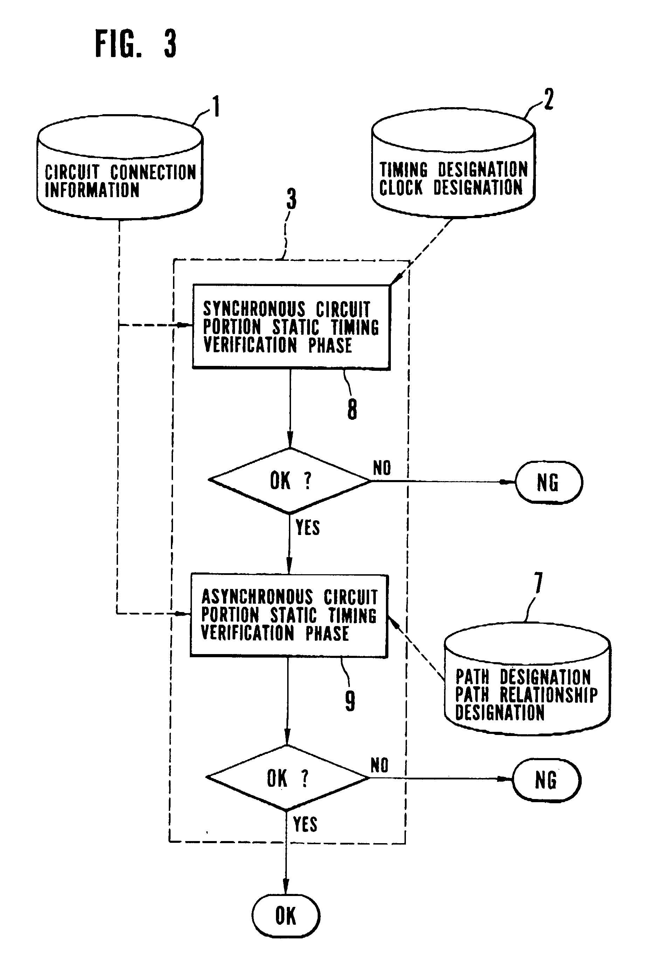

Fig. 3 shows a flow of process in a static timing verification device 3. In Fig. 3, reference numeral 8 denotes a static timing verification phase for a synchronous circuit portion while 9 denotes a static timing verification phase for an asynchronous circuit portion.

Operation of the embodiment according to the invention is now described.

First, as shown in Fig. 2, the flow of process in the timing verification according to the embodiment differs from the conventional flow of process shown in Fig. 1 in that no dynamic timing verification device for an asynchronous circuit portion is provided. Specifically, in the embodiment of the invention, since the timing verification of the asynchronous circuit portion is performed by the static timing verification device, no dynamic timing verification device for the asynchronous circuit portion is required.

With reference to Fig. 3 for the verification method in the static verification device 3, the verification phase 8 for the synchronous circuit portion is now described.

According to the embodiment of the invention, in the static timing verification device, basically without using the signal information of each circuit element by means of simulation, by designating timing and clock of an input/output signal (refer to the timing designation and clock designation information 2), a latest path (critical path) is found between latches in a circuit portion which is synchronous with a clock designated signal to verify a setup timing by determining whether or not the path is in time as compared with a clock cycle. Also, a fastest path between the latches is found to verify a hold timing by determining whether or not the next data is taken in at the timing of the same clock. The verification means takes the same method as the prior-art static timing verification tool shown in Fig. 1.

The verification phase 9 for the asynchronous circuit portion in the timing verification device 3 according to the embodiment of the invention is now described.

First, in the asynchronous circuit portion a delay information in the paths designated in the measured path designation and path relationship designation information 7 is extracted. When extracting the delay information, the path delay data which is already extracted in the static timing verification phase 8 for the synchronous circuit portion can be used.

Subsequently, by using the extracted value (the delay value of the designated path), it is verified whether or not the path relationship information designated in the measured path designation and path relationship designation information 7 in the asynchronous circuit portion is satisfied. Thus, the timing of the asynchronous circuit portion is verified.

FIRST EMBODIMENT

With reference to the accompanying drawings the embodiment of the invention is further detailed. In the following, only the characteristic verification method for the asynchronous circuit portion according to the invention is described, which differs from the conventional dynamic timing verification device. For the verification method for the synchronous circuit portion in the same manner as the conventional static timing verification device, its description is omitted.

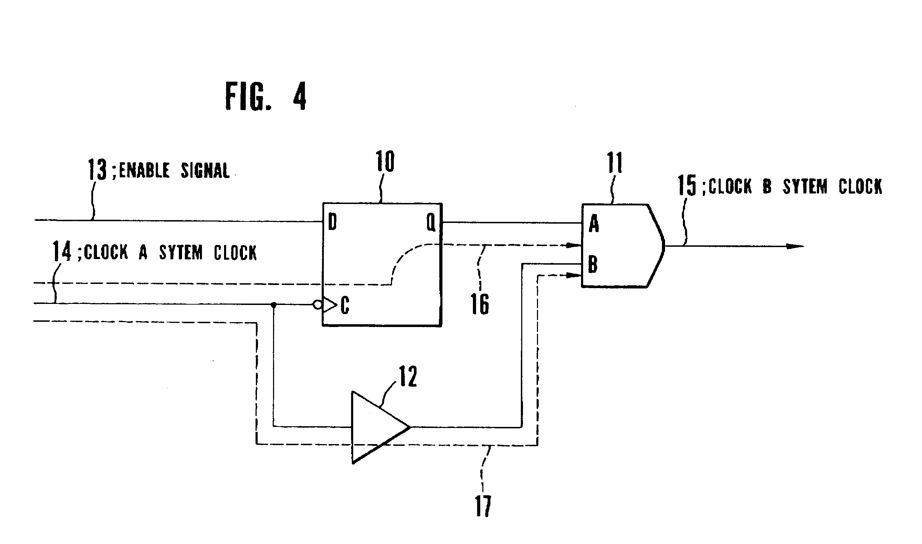

Fig. 4 is an explanatory view of a first embodiment according to the invention, showing a constitution of a sample circuit to depict the static timing verification method for the asynchronous circuit portion. In Fig. 4, reference numeral 10 denotes a fall synchronous flip-flop (hereinafter, referred to as FF), 11 a two-input AND circuit, 12 a buffer circuit, 13 an enable signal, 14 a clock A system clock, and 15 a clock B system clock.

As shown in Fig. 4, the enable signal 13 is connected to a data input terminal D of the FF10, the clock A system clock 14 is connected to a clock input terminal C of the FF10 and to an input terminal of the buffer circuit 12, an output terminal Q of the FF10 is connected to an input terminal A of the AND circuit 11, an output terminal of the buffer circuit 12 is connected to the other input terminal B of the AND circuit 11, and an output terminal of the AND circuit 11 emits the clock B system clock 15. The clock B system clock 15 is prepared from the clock A system clock 14, and supplied as an active clock only when the enable signal 13 is logically "1".

Also in Fig. 4, a broken line 16 denotes a path delay of [the output of the clock A system clock 14]-[the clock input C of the FF10]-[the output Q of the FF10]-[the input A of the AND circuit 11].

Also, a broken line 17 denotes a path delay of [the output of the clock A system clock 14]-[the output of the buffer circuit 12]-[the input B of the AND circuit 11].

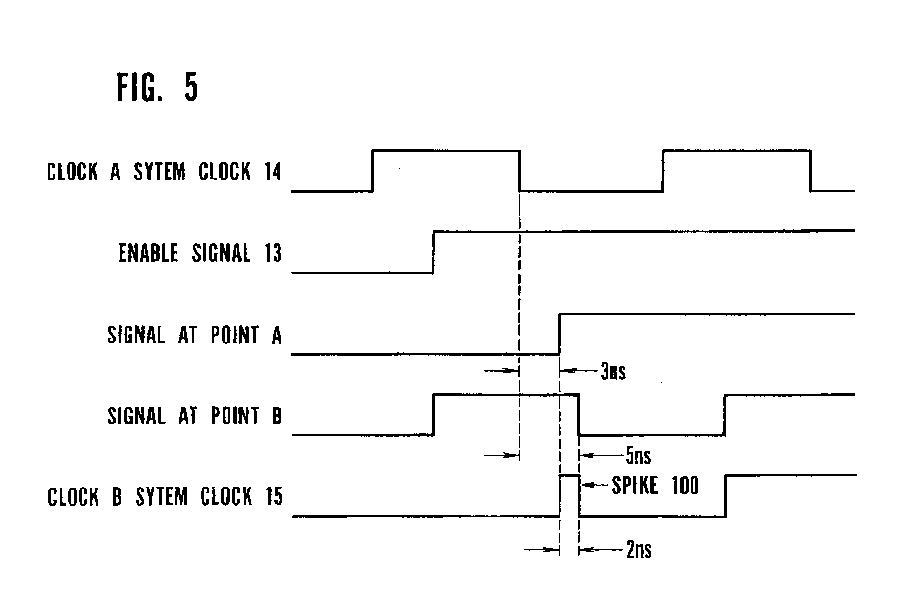

In the sample circuit, when the path delay 16 is smaller than the path delay 17, for example, when the path delay 16 is 3ns and the path delay 17 is Sns, then, as shown in the timing chart of Fig. 5, on the output of the clock B system clock 15 a spike 100 with a pulse width of about 2ns rides. In some circuit constitution, the spike 100 may cause a malfunction in the circuit. Therefore, the spike needs to be prevented from occurring.

In Fig. 3, in the information 7 which indicates the paths to be measured in the asynchronous circuit portion and the path relationship designated are paths:

(a) from the output of the clock A system clock 14 to the clock input of the FF10;
(b) from the clock input of the FF10 to the data output of the FF10;
(c) from the data output of the FF10 to the data input of the AND circuit 11;
(d) from the output of the clock A system clock 14 to the input of the buffer circuit 12; and
(e) from the input of the buffer circuit 12 to the data input of the AND circuit 11.

Also, following path relationship is designated.

$$\{(a)+(b)+(c)\}>\{(d)+(e)\} \tag{1}$$

In Fig. 3, in the asynchronous circuit portion static verification phase 9 respective delays of (a), (b), (c), (d) and (e) are measured, and based on the delay values it is verified whether or not the delay values satisfy the path relationship.

SECOND EMBODIMENT

A second embodiment of the invention is described with reference to the accompanying drawings.

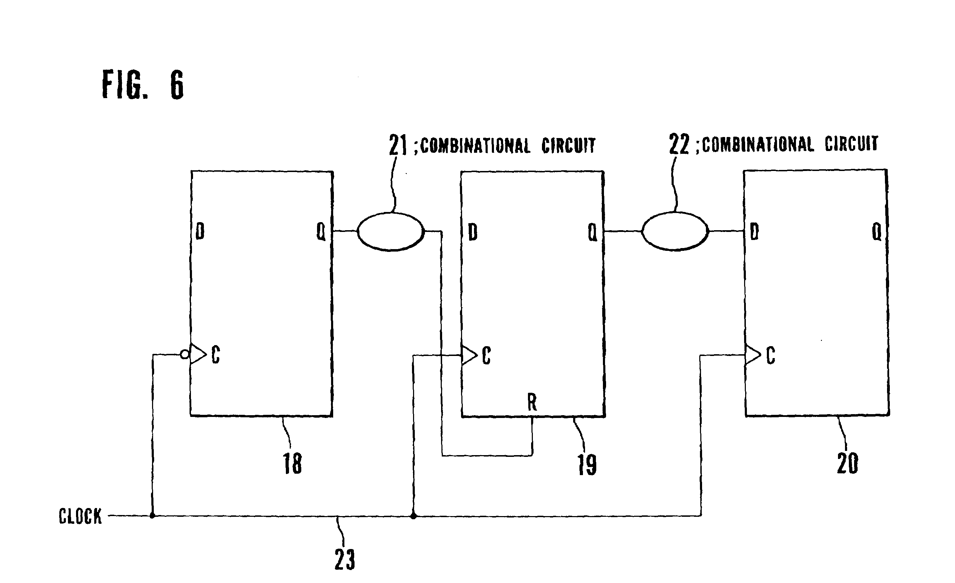

Fig. 6 shows a constitution of another sample circuit for the static timing verification for the asynchronous circuit portion. In Fig. 6, reference numeral 18 denotes a fall synchronous flip-flop (hereinafter, referred to as FF), 19 a rise synchronous flip-flop with a reset, 20 a rise synchronous flip-flop, 21 and 22 combinational circuits, and 23 a clock.

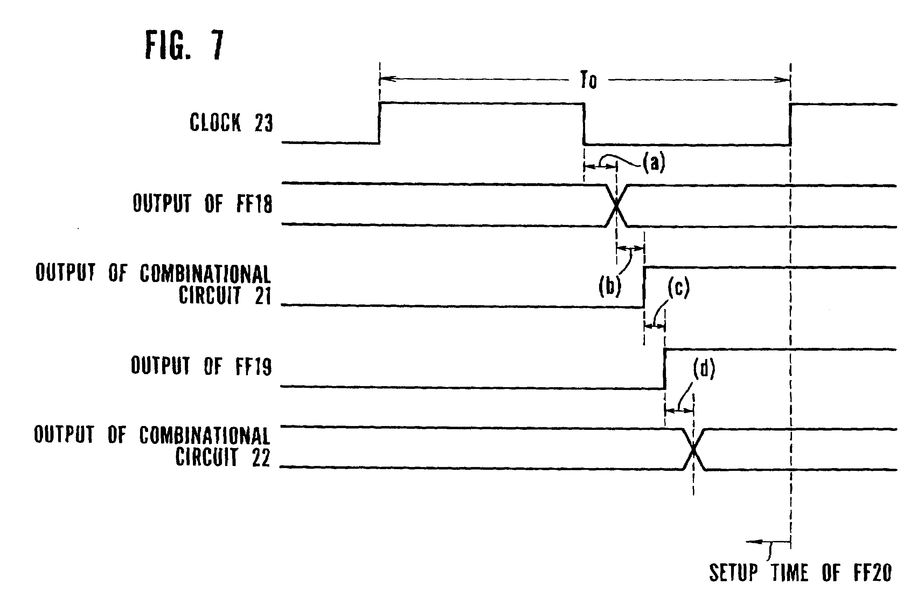

Fig. 7 shows a timing chart of the sample circuit shown in Fig. 6. The clock 23 is connected in common to clock terminals of the FF18, the FF19 and the FF20. An output Q of the FF18 is transmitted to the combinational circuit 21, an output of the combinational circuit 21 is transmitted to a reset terminal R of the FF19, an output Q of the FF19 is transmitted to the combinational circuit 22, and an output of the combinational circuit 22 is transmitted to a data input terminal D of the FF20.

In the circuit of Fig. 6, synchronously with the fall of the clock 23 the output of the fall synchronous FF18 changes, which changes the output of the combinational circuit 21 to logical "1" to reset the FF19. A signal which is obtained by passing the output of the FF19 via the combinational circuit 22 is transmitted to the FF20. If the signal has to be taken in when the clock 23 rises, referring to Fig. 3, in the information 7 which indicates the paths to be measured in the asynchronous circuit portion and the path relationship designated are paths:

(a) from the clock input of the FF18 to the output of the FF18;
(b) from the output of the FF18 via the combinational circuit 21 to the reset input of the FF19;
(c) from the reset input of the FF19 to the output of the FF19; and
(d) from the output of the FF19 via the combinational circuit 22 to the input of the FF20.

Also, following path relationship is designated.

$$\{[\text{period } T_0 \text{ of clock 23}] \times [\text{duty}(\%) \text{ on Low side of clock}$$

$$23]/100\} > \{(a)+(b)+(c)+(d)\}+[\text{setup time } T_{SETUP} \text{ of FF20}]\} \qquad (2) \text{ (refer to Fig. 7)}$$

In the static timing verification phase 9 for asynchronous circuit portion the respective path delays are calculated, and it is verified whether or not the path relationship is satisfied.

Also, the implementation of the static timing verification phase for the aforementioned high asynchronous lob is controlled in accordance with a program executed on a computer or another information processing device.

As aforementioned, according to the invention, for a synchronous circuit/asynchronous circuit mixed circuit, without performing a dynamic timing verification, a circuit timing can be advantageously assured.

Specifically, according to the invention, the static timing verification device the timing realizes not only the timing verification for the synchronous circuit but also the timing verification for the asynchronous circuit by designating the delay circuits and path relationship. As a result, according to the invention, a time required for the timing verification can be advantageously shortened remarkably.

## Claims

1. A timing verification method for a synchronous circuit/asynchronous circuit mixed circuit wherein paths in a circuit portion in which a delay becomes a problem associated with an asynchronous circuit portion are designated, delay information of said paths is obtained, and it is verified whether or not the delay information satisfies a delay relationship designated among said paths in said circuit portion, so that a timing verification for the asynchronous circuit portion is performed only by means of a static timing verification without using a test pattern.

2. A timing verification method for a synchronous circuit/asynchronous circuit mixed circuit wherein to verify a timing of an asynchronous circuit portion a path delay data which has been extracted in a synchronous circuit portion static timing verification phase is used if available and it is verified from an extracted delay data of paths designated in said asynchronous circuit portion whether or not path delays of said paths satisfy a desired delay condition, so that a timing verification for the asynchronous circuit portion is performed only by means of a static timing verification without using a test pattern.

3. A timing verification device for verifying a timing of a synchronous circuit/asynchronous circuit mixed circuit which comprises:

a means for storing paths and a path relationship information designated in a circuit portion in which a delay becomes a problem associated with an asynchronous circuit portion; and
a means for verifying from delay values obtained of said designated paths whether or not the delay values of the paths satisfy a delay condition which is designated for said paths,
a timing verification not only for a synchronous circuit but also for an asynchronous circuit portion being performed only by means of a static timing verification without using a test pattern.

4. A record medium for recording a program for executing a timing verification on an information processing device wherein to verify a timing of an asynchronous circuit portion in a synchronous circuit/asynchronous circuit mixed circuit, a path delay data which has been extracted in a synchronous circuit portion static timing verification phase is used if available and it is verified from an extracted delay data of paths designated in said asynchronous circuit portion whether or not path delays of said paths satisfy a desired delay condition, so that a timing verification for the asynchronous circuit portion is performed only by means of a static timing verification without using a test pattern.

# FIG. 1   PRIOR ART

TO NEXT PROCESS

# FIG. 2

# FIG. 3

# FIG. 4

13 ; ENABLE SIGNAL

10

11

15 ; CLOCK B SYTEM CLOCK

14 ; CLOCK A SYTEM CLOCK

D    Q

C

A

B

16

12

17

EP 0 853 280 A2

# FIG. 5

CLOCK A SYTEM CLOCK 14

ENABLE SIGNAL 13

SIGNAL AT POINT A

3ns

SIGNAL AT POINT B

5ns

CLOCK B SYTEM CLOCK 15

SPIKE 100

2ns

EP 0 853 280 A2

# FIG. 6

# FIG. 7

CLOCK 23

$T_0$

OUTPUT OF FF18

(a)

OUTPUT OF COMBINATIONAL CIRCUIT 21

(b)  (c)

OUTPUT OF FF19

(d)

OUTPUT OF COMBINATIONAL CIRCUIT 22

SETUP TIME OF FF20

EP 0 853 280 A2